# EUROPÄISCHE PATENTANMELDUNG

(11) **EP 1 263 046 A1**
(43) Veröffentlichungstag der Anmeldung: **04.12.2002**
(21) Anmeldenummer: 01113344.4
(22) Anmeldetag: 01.06.2001
(51) Int. Cl.: H01L 25/11, H01L 23/051

(54) **Kontaktanordnung**

(71) Anmelder: ABB Schweiz AG, 5400 Baden (CH)
(72) Erfinder: Kaufmann Stefan, CH-5000 Aarau (CH)
(74) Vertreter: ABB Patent Attorneys

(57) **Zusammenfassung**

Das Leistungshalbleitermodul umfasst ein Modulgehäuse mit einer leitfähigen Deckelplatte (2) und einer leitfähigen Grundplatte sowie einer zwischen der Deckelplatte und der Grundplatte angeordneten, isolierenden Gehäusewand (3). Im Modulgehäuse ist eine Leistungshalbleiterschaltung untergebracht. Zwei Anschlüsse (5, 6) der Leistungshalbleiterschaltung sind aus dem Modulgehäuse herausgeführt, wobei ein erster (5) der mindestens zwei Anschlüsse zum Kontaktieren der Deckelplatte vorgesehen ist. Die beiden Anschlüsse (5, 6) sind auf gegenüberliegenden Flächen einer aus dem Modulgehäuse herausgeführten, mit einem Standardstecker kontaktierbaren Leiterplatte (4) angeordnet.

Das erfindungsgemässe Leistungshalbleitermodul weist betreffend der Stabilität und der Induktivität verbesserte Kontakte auf.

## Beschreibung

### Technisches Gebiet

Die Erfindung bezieht sich auf das Gebiet der Leistungselektronik. Sie geht aus von einem Leistungshalbleitermodul gemäss dem Oberbegriff des Patentanspruchs 1.

### Stand der Technik

Die Gate und auxiliary Emitter Kontakte von herkömmlichen ,Hockeypuck'- Thyristoren rsp. IGBTs bestehen aus herausstehenden Stiften, an das Gehäuse angelötet sind. Diese können bei Einwirkungen von Gewalt leicht abbrechen. Zusätzlich ist die Induktivität zwischen diesen Kontakten relativ hoch.

### Kurze Darstellung der Erfindung

Die Aufgabe der Erfindung besteht folglich darin, eine betreffend der Stabilität der Kontakte und der Induktivität zwischen den Kontakten verbessertes Leistungshalbleitermodul der eingangs genannten Art zu schaffen.

Diese Aufgabe wird mit einem Leistungshalbleitermodul mit den Merkmalen des Patentanspruchs 1 gelöst.

Der Kern der Erfindung besteht darin, dass die beiden aus dem Modulgehäuse herausgeführten Anschlüsse der Leistungshalbleiterschaltung auf gegenüberliegenden Flächen einer aus dem Modulgehäuse herausgeführten Leiterplatte (printed circuit board, PCB) angeordnet sind.

Die Leiterplatte weist eine gegenüber den Anschlüssen von herkömmlichen Leistungshalbleitermodulen erhöhte Stabilität bei geringerer Induktivität auf.

In einer bevorzugten Ausführungsform des erfindungsgemässen Leistungshalbleitermoduls ist die Leiterplatte mit Befestigungsmittel an der Deckelplatte kraftschlüssig befestigt, so dass der zwischen Leiterplatte und Deckelplatte angeordnete Deckelplatten-Anschluss mit der Deckelplatte elektrisch leitfähig verbunden ist, wobei das Befestigungsmittel vorteilhafterweise im Bereich der Verbindungsstelle angeordnet ist.

Dadurch ist eine optimale elektrische Verbindung zwischen der Deckelplatte und dem Deckelplatten-Anschluss gewährleistet.

Vorteilhafterweise weisen die Deckelplatte und/ oder der Deckelplatten-Anschluss im Bereich der Verbindungsstelle eine Rändelung auf. Dadurch wird die elektrische Verbindung zusätzlich verbessert. Ein sicherer elektrischer Kontakt über eine längere Zeit kann so selbst bei variablen Bedingungen (Temperatur, Feuchtigkeit) erreicht werden.

In einer weiteren bevorzugten Ausführungsform des erfindungsgemässen Leistungshalbleitermoduls weisen die Deckel- und die Leiterplatte je mindestens zwei Vorsprünge auf. Jeweils ein Vorsprung der Deckel- und der Leiterplatte sind übereinander angeordnet und die Befestigungsmittel sind im Bereich der Vorsprünge angeordnet. Zudem weist die Leiterplatte zwischen den beiden Vorsprüngen mindestens einen weiteren Vorsprung auf.

Die beiden Vorsprünge der Deckelplatte sorgen dafür, dass der weitere Vorsprung der Leiterplatte gegenüber Schlägen geschützt ist. Dieser Vorsprung ist vorteilhafterweise im Wesentlichen reckteckig ausgebildet, damit er mit einem herkömmlichen Stecker kontaktiert werden kann.

### Kurze Beschreibung der Zeichnungen

Eine detaillierte Beschreibung der Erfindung erfolgt nachstehend anhand von Ausführungsbeispielen, die in den Zeichnungen dargestellt sind. Dabei zeigen
- Fig. 1: schematisch dargestellt, ein erfindungsgemässes Leistungshalbleitermodul, mit einer Deckelplatte und einer Leiterplatte,
- Fig. 2: einen Teil eines Leistungshalbleitermoduls nach Fig. 1, mit der Deckelplatte und einer ersten Ausführungsform der Leiterplatte,
- Fig. 3: eine Ansicht auf einen entlang III-III geführten Schnitt durch das Leistungshalbleitermodul nach Fig. 2,
- Fig. 4: eine Ansicht auf einen entlang IV-IV geführten Schnitt durch das Leistungshalbleitermodul nach Fig. 2,
- Fig. 5: eine Ansicht von oben auf eine zweite Ausführungsform der Leiterplatte nach Fig. 2, und
- Fig. 6: eine Ansicht von unten auf die Leiterplatte nach Fig. 5.

### Weg zur Ausführung der Erfindung

In allen Figuren beziehen sich gleiche Bezugszeichen auf gleichwirkende Teile.

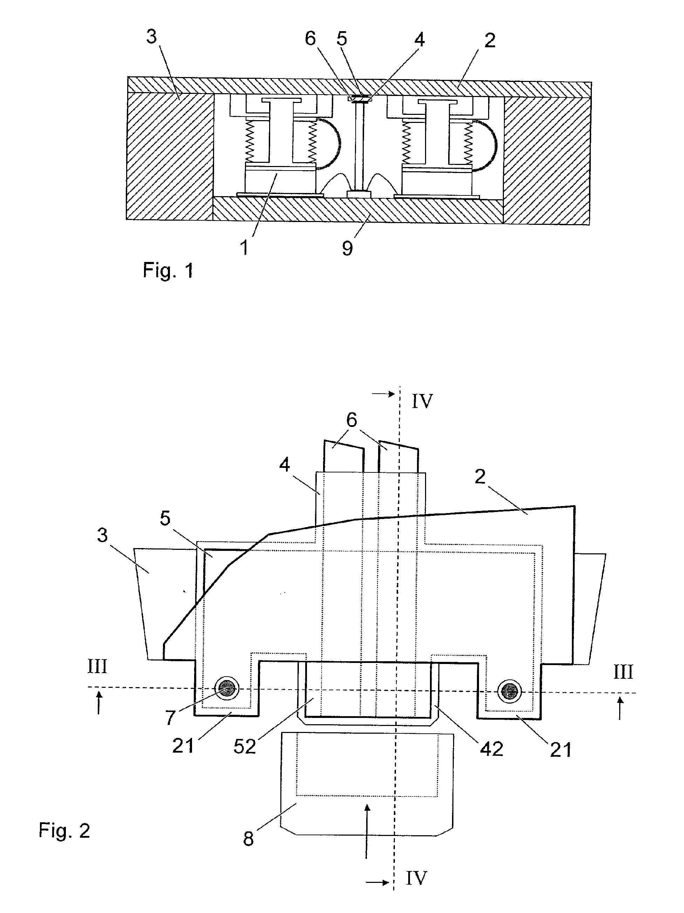

Das Leistungshalbleitermodul in Fig. 1 umfasst eine Leistungshalbleiterschaltung 1 bestehtend aus zwei Leistungshalbleitern. Die Funktion und der Aufbau der Leistungshalbleiterschaltung ist beliebig und für die Erfindung nicht relevant. So können beispielsweise mehrere Halbleiterelemente in vorfabrizierbaren Submodulen zusammengefasst sein.

Die Leistungshalbleiterschaltung 1 ist in einem Modulgehäuse untergebracht, welches im Wesentlichen aus einer elektrisch leitenden Deckelplatte 2, einer elektrisch leitenden Grundplatte 9 sowie dazwischen angeordneten elektrisch isolierenden Gehäusewänden 3 besteht.

Steuersignale für die Leistungshalbleiter, beispielsweise Gate-Steuersignale für Insulated Gate Bipolar Transistor (IGBT), werden über eine Sammelschiene und einen Steuer-Anschlussleiter 6 aus dem Gehäuse geführt.

Der Steuer-Anschlussleiter 6 ist erfindungsgemäss auf der einen Seite einer beidseitig metallisierten Leiterplatte 4 angeordnet. Auf der anderen Seite der Leiterplatte befindet sich der Deckelplatten-Anschlussleiter 5, welcher mit der Deckelplatte 2 elektrisch leitend verbunden ist.

Fig. 2 zeigt einen Teil des erfindungsgemässen Leistungshalbleitermoduls von oben betrachtet.

Zwischen der Gehäusewand 3 und der Deckelplatte 2 ist die beidseitig metallisierte Leiterplatte 4 angeordnet. Auf der oberen, der Deckelplatte zugewandten Seite befindet sich der Deckel-Anschlussleiter 5. Auf der unteren, der Gehäusewand zugewandten Seite befinden sich zwei Steuer-Anschlussleiter 6.

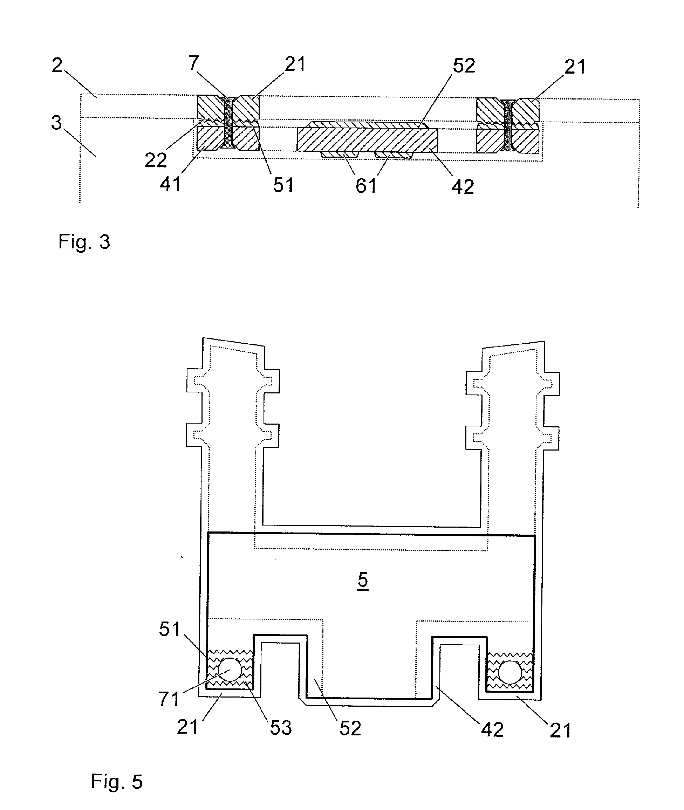

Die Deckelplatte 2 weist zwei Vorsprünge 21 auf, welche über den Modulgehäuserand hervorstehen. Wie aus Fig. 3 ersichtlich ist, weist die Leiterplatte zwei entsprechende Vorsprünge 41 auf, welche unterhalb der Vorsprünge 21 der Deckelplatte angeordnet sind. Die Vorsprünge 21 und 41 sind mit einem Befestigungsmittel 7, beispielsweise einer Niete oder einer Schraube, verbunden. Dadurch wird zwischen dem auf der Oberseite der Leiterplatte angeordneten Deckelplatten-Anschlussleiter 51 und der Deckelplatte 21 eine elektrisch leitende Verbindung erstellt. In die Unterseite des Vorsprungs 21 der Deckelplatte ist eine Rändelung 22 (aufgerauhte Oberfläche) eingelassen. Indem die bis zu einigen 100 µm langen Spitzen der Rändelung in die Metallisierung der Leiterplatte gedrückt werden, ergibt sich eine verbesserte elektrische Verbindung.

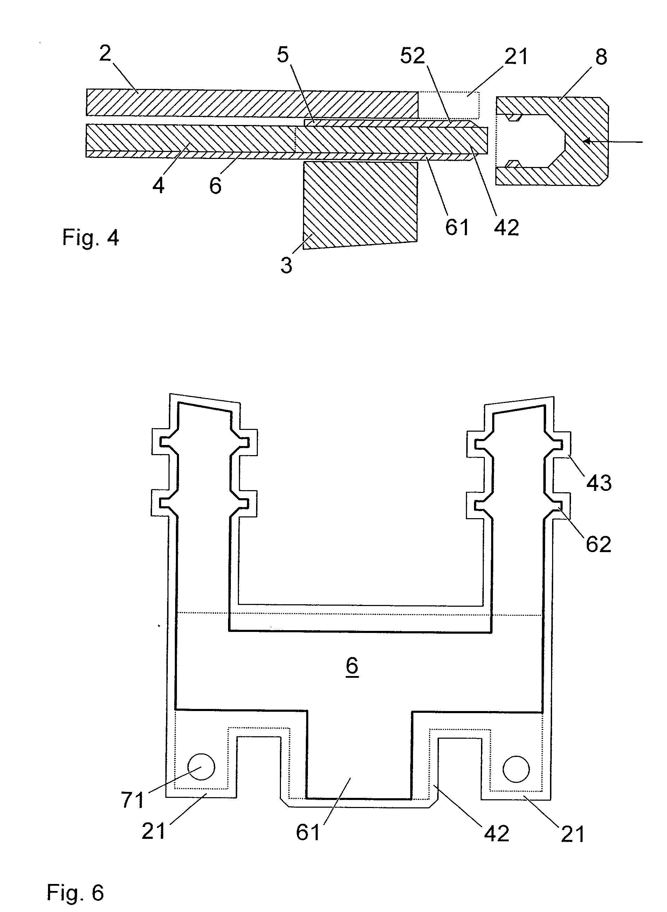

Zwischen den beiden Vorsprüngen 41 weist die Leiterplatte einen weiteren Vorsprung 42 auf. Dieser Vorsprung 42 dient der Aufnahme eines Steckers 8, wie aus Fig. 4 ersichtlich ist. Der Stecker 8 wird in Pfeilrichtung auf den Vorsprung 42 aufgeschoben. Im Stecker angeordnete Kontaktelemente werden auf die beidseits der Leiterplatte 4 angeordneten Anschlüsse 52 und 61 geschoben. Als Stecker können herkömmliche Leiterplatten-Stecker verwendet werden.

Der Vorsprung 42 ist durch die Deckelplatten-Vorsprünge 21 gegen Schläge von oben und von der Seite geschützt.

Fig. 5 und Fig. 6 zeigen eine andere Ausführungsform der Leiterplatte mit nur einem Steuer-Anschluss 61. Zudem ist im Bereich der Aussparung 71 für die Befestigungsmittel eine Rändelung 53 in den Deckelplatten-Anschlussleiter 51 eingelassen. Durch die aufgerauhte Oberfläche ergibt sich eine verbesserte elektrische Verbindung zur Deckelplatte.

Die Leiterplatte umfasst im Innern des Modulgehäuses weitere Vorsprünge 43, welche der Kontaktierung der Steuer-Sammelschiene dienen. Vertikale Kontaktelemente (nicht gezeigt) verbinden den Steuer-Anschlussleiter 62 mit der Sammelschiene. Neben den in den Vorsprüngen 21 eingelassenen Aussparungen 71 können Aussparungen für weitere Befestigungsmittel vorgesehen werden.

Neben den gezeigten Ausführungsformen ist es denkbar, mehrere nebeneinander angeordnete Vorsprünge für mehrere Stecker zu verwenden. Dabei kann jeweils zwischen den einzelnen Stecker ein Deckelplatten-Vorsprung zum Schutz des jeweiligen Vorsprungs vorgesehen sein.

Zudem ist es denkbar, mehr als ein oder zwei Steuer-Anschlüsse pro Leiterplattenvorsprung vorzusehen.

Insbesondere sind auch Ausführungsbeispiele denkbar, mit drei- oder mehrlagigen Leiterplatten, bei der jede Leiterlage mindestens einen Anschluss umfasst.

### Bezugszeichenliste

- 1: Leistungshalbleiterschaltung
- 2: Leitfähige Deckelplatte, Emitterplatte
- 3: Isolierendes Gehäuse
- 4: Isolierende Leiterplatte
- 5, 51: Deckelplatten-Anschlussleiter
- 6, 62: Steuer-Anschlussleiter
- 7: Befestigungsmittel
- 8: Anschluss-Stecker
- 9: Leitfähige Grundplatte
- 21, 41, 42,43: Vorsprung
- 22, 53: Rändelung
- 52: Deckelplatten-Anschluss
- 61: Steuer-Anschluss
- 71: Aussparung für Befestigungsmittel

## Patentansprüche

1. Leistungshalbleitermodul, umfassend
- ein Modulgehäuse mit einer leitfähigen Deckelplatte (2) und einer im Wesentlichen parallel zu der Deckelplatte angeordneten, leitfähigen Grundplatte (9), sowie einer zwischen der Deckel- und der Grundplatte angeordneten, isolierenden Gehäusewand (3),
- eine in dem Modulgehäuse untergebrachte Leistungshalbleiterschaltung (1), sowie
- mindestens zwei aus dem Modulgehäuse herausgeführte Anschlüsse (5, 52; 6, 61) der Leistungshalbleiterschaltung, wobei ein erster (5, 52) der mindestens zwei Anschlüsse zum Kontaktieren der Deckelplatte (2) vorgesehen ist,
**dadurch gekennzeichnet, dass**
- eine im Wesentlichen flach ausgebildete Leiterplatte (4) aus dem Modulgehäuse herausgeführt ist, dass
- die Leiterplatte (4) mindestens zweilagig ausgebildet ist, dass
- die beiden Anschlüsse als Leiter (5, 6) der Leiterplatte (4) ausgebildet sind, und dass
- die Leiter (5, 6) im Wesentlichen parallel zu den Grundflächen der Leiterplatte (4) angeordnet sind.

2. Leistungshalbleitermodul nach Anspruch 1, **dadurch gekennzeichnet, dass**
- die Leiterplatte (4) mit Befestigungsmittel (7) an der Deckelplatte (2) kraftschlüssig befestigt ist, so dass der auf der Deckelplatte zugewandten Seite der Leiterplatte angeordnete Deckelplatten-Anschlussleiter (5) mit der Deckelplatte elektrisch leitfähig verbunden ist.

3. Leistungshalbleitermodul nach Anspruch 2, **dadurch gekennzeichnet, dass**
- die Befestigungsmittel (7) im Bereich der Verbindungsstelle angeordnet sind.

4. Leistungshalbleitermodul nach einem der Ansprüche 2 oder 3, **dadurch gekennzeichnet, dass**
- die Deckelplatte (2) und/ oder der Deckelplatten-Anschlussleiter (5, 51) im Bereich der Verbindungsstelle eine kontaktoptimierende Rändelung (22, 53) aufweist.

5. Leistungshalbleitermodul nach einem der Ansprüche 2 bis 4, **dadurch gekennzeichnet, dass**
- die Deckelplatte (2) und die Leiterplatte (4) je mindestens zwei Vorsprünge (21) aufweisen, dass
- jeweils ein Vorsprung der Deckelplatte (21) und der Leiterplatte (41) übereinander angeordnet sind, dass
- die Befestigungsmittel (7) im Bereich der Vorsprünge (21, 41) angeordnet sind, dass
- die Leiterplatte (4) zwischen den beiden Vorsprüngen (41) mindestens einen weiteren Vorsprung (42) aufweist, und dass
- auf diesem weiteren Vorsprung (42) die Anschlüsse (52, 61) angeordnet sind.
